Europäisches Patentamt

(19) European Patent Office

Office européen des brevets

(11) Publication number:

**0 329 414**

**A2**

(12) **EUROPEAN PATENT APPLICATION**

(21) Application number: **89301441.5**

(22) Date of filing: **15.02.89**

(51) Int. Cl.⁴: **H 05 K 1/00**
**H 05 K 3/10**

(30) Priority: **19.02.88 GB 8803891**

(43) Date of publication of application:
**23.08.89 Bulletin 89/34**

(84) Designated Contracting States:
**AT BE CH DE ES FR GB GR IT LI LU NL SE**

(71) Applicant: **BICC Public Limited Company**
**Devonshire House Mayfair Place**
**London W1X 5FH (GB)**

(72) Inventor: **Lawrence, Howard**
**P.O.Box 37047 Stokes Valley**
**Wellington (NZ)**

(74) Representative: **Ross Gower, Edward Lewis et al**
**BICC Group Patents & Licensing Department Network**
**House 1 Ariel Way**
**London W12 7SL (GB)**

(54) **An improved circuit board.**

(57) A printed circuit board which is of such a construction that patterns of electrically conductive strips and/or pads of either standard or non-standard form can be readily provided comprises a rigid board 1 of which at least the major surfaces are of electrically insulating material, which has extending through the board a multiplicity of holes 2 arranged in a pattern of rows and columns and which carries on one or each of its major surfaces a multiplicity of annular metal islands 3 each bounding a hole in the board and discrete with respect to the other annular islands. The rigid board 1 may also carry on said one or each of its major surfaces supplementary metal islands 4 and 5 each positioned between and discrete with respect to annular islands bounding adjacent holes in the rigid board. A circuit of either a standard or non-standard pattern can be formed by electrically interconnecting selected adjacent metal islands 3, 4 and 5 with local deposits of material of high electrical conductivity in such a way as to bridge the gap between adjacent islands. The local deposits may be effected manually but are preferably effected automatically using a modified computer aided design plotter or an automatic fluid dispensing machine.

*Fig. 1.*

**Description**

## AN IMPROVED CIRCUIT BOARD

This invention relates to circuit boards of the kind comprising a substantially rigid board of which at least the major surfaces are of electrically insulating material, which carries on one or each of its major surfaces a pattern of strips and/or pads of metal or metal alloy of high electrical conductivity, usually but not necessarily copper, and which has, extending through the board and underlying the electrically conductive metal strips and/or pads, a multiplicity of mutually spaced holes. Circuit boards of this kind will hereinafter, for convenience, be referred to as "circuit boards of the kind described".

It is the general practice for a manufacturer of circuit boards to provide circuit boards of the kind described having any one of a plurality of standard patterns of electrically conductive strips and/or pads on one or each of its major surfaces and for a user of a circuit board to modify the or each pattern on a board as required by removal of appropriate portions of the electrically conductive strips and/or by removal of appropriate electrically conductive pads. Circuit boards of the kind described having standard patterns of electrically conductive strips and/or pads are especially suitable for use in the manufacture of prototype circuits. If none of the standard patterns of electrically conductive strips and/or pads available on circuit boards of the kind described can be conveniently modified by removal of appropriate portions of the strips and/or removal of appropriate pads, a user has to arrange for a manufacturer to provide a circuit board of the kind described with a non-standard pattern of electrically conductive strips and/or pads on one or each of its major surfaces. Manufacture of such non-standard items is unpopular with manufacturers because it necessitates a change in manufacturing procedure and is unpopular with users because there is inevitably a delay in obtaining circuit boards of the kind described having non-standard patterns of electrically conductive strips and/or pads and because such circuit boards are expensive.

It is an object of the present invention to provide an improved circuit board of the kind described which is of such a construction that patterns of electrically conductive strips and/or pads of either standard or non-standard form can be readily provided and which, in one preferred form, is especially, but not exclusively, suitable for design and assembly by a user.

According to the invention, the improved circuit board comprises a substantially rigid board of which at least the major surfaces are of electrically insulating material, which has extending through the rigid board a multiplicity of holes arranged in a pattern of rows and columns and which carries on one or each of its major surfaces a multiplicity of islands of metal or metal alloy of high electrical conductivity each of which islands at least partially bounds a hole in the board and is discrete with respect to the other said islands.

Preferably, the metal or metal alloy of each island at least partially bounding a hole in the rigid board extends into and lines the hole over at least a part of its length.

The improved circuit board has the important advantage that a user can readily form on one or each major surface of the improved circuit board a circuit of either a standard or non-standard pattern by electrically interconnecting selected adjacent islands of metal or metal alloy with local deposits of a material of high electrical conductivity in such a way as to bridge the gap between said adjacent islands.

Local deposits of a material of high electrical conductivity to bridge and effectively interconnect adjacent islands of metal or metal alloy may be effected manually in accordance with a selected pattern, for example, by means of a pen, but preferably such local deposits are readily effected automatically using a modified computer aided design plotter (CAD) or an automatic fluid dispensing machine which can be used to operate a pen or applicator by pulses of air pressure to deposit electrically conductive material on to the rigid board.

Preferably, the electrically conductive material employed for applying local deposits on a major surface of the circuit board of the present invention to bridge and effectively interconnect adjacent islands of metal or metal alloy is in the form of an electrically conductive ink comprising a plastics material, e.g. a polymeric material, loaded with a multiplicity of particles of a metal or metal alloy of high electrical conductivity, e.g. silver, nickel or copper.

The multiplicity of islands of metal or metal alloy at least partially bounding holes in the rigid board preferably are of substantially the same shape as one another and, in a preferred embodiment, each of these islands has an outer periphery of substantially circular shape.

The rigid board of the improved circuit board preferably also carries on said one or each of its major surfaces supplementary islands of metal or metal alloy of high electrical conductivity, each of which supplementary islands is positioned between and is discrete with respect to islands at least partially bounding adjacent holes in the rigid board. The supplementary islands may be in any pattern and may be of several shapes differing from one another including, for example, short tracks of rectilinear and non-rectilinear shape and pads of circular and non-circular shape.

Each island preferably comprises a coating of copper or copper alloy.

Where the electrical conductivity of the material to be locally deposited on an improved circuit board to bridge the gap between adjacent islands is less than that of the metal or metal alloy of the islands, preferably each island has a major width which is substantially greater than the width of the metal strips and/or pads of known circuit boards of the kind described. For example, when the holes in the rigid board of the improved circuit board are arranged in a pattern of rows and columns with the centres of adjacent holes spaced by 2.54 mm and a material to be deposited on the improved circuit board is a polymeric material loaded with a multiplicity of metal particles, each island is of copper or copper alloy and has a width of approximately 0.5mm as compared with a width of 0.3mm of the metal strips and/or pads of known circuit boards of the kind described. The substantial width of the islands compensates for the lower conductivity of the material of the local deposits and creates a bigger target for application of the deposits. In the improved circuit board, the metal or metal alloy of the islands may cover as much as 90% of the area of a major surface of the rigid board.

In one preferred embodiment of the invention, a separately formed flexible sheet of electrically insulating material is secured to at least one major surface of the rigid board and carries on the surface of the flexible sheet remote from the rigid board a multiplicity of islands of metal or metal alloy each bounding and overlying a hole in the rigid board, the metal or metal alloy of each island being of such thickness that, when a pin is urged through an electrically conductive island into an underlying hole in the rigid board, metal or metal alloy pierced by the pin will effect an electrical contact with the pin passing therethrough.

The or each separately formed flexible sheet may be made of any suitable electrically insulating plastics material but, preferably, the or each flexible sheet is made of an electrically insulating plastics material having such inherent elasticity that, when the flexible sheet is pierced by a pin, the inherent elasticity of the plastics material tends to urge the metal or metal alloy of the pierced island into electrical contact with the pin. Preferably, also, the electrically insulating plastics material of the or each flexible sheet is transparent or translucent. Preferred electrically insulating plastics materials having appropriate inherent elasticity include polyimides, e.g. that sold under the registered trade mark "KAPTON", and polyesters. By virtue of making the or each flexible sheet of an electrically insulating material having appropriate inherent elasticity, we have found that a contact pin can be removed and replaced a plurality of times without any unacceptable deterioration of the electrical contact between the pin and the electrically conductive metal or metal alloy of the pierced island.

The improved circuit board of the present invention can be used in the construction of a circuit board assembly comprising at least two improved circuit boards secured one on top of the other with a separately formed layer of insulating material sandwiched between adjacent circuit boards and having a multiplicity of holes in alignment with the multiplicity of holes of each adjacent circuit board. Adjacent circuit boards may be secured together by adhesive or double-sided adhesive tape around their peripheries and, where necessary, at selected areas of the boards. A circuit of either a standard or non-standard pattern can be formed on one or each major surface of each circuit board before the boards are secured together and, where the boards are each made of an electrically insulating material and a multiplicity of islands of metal or metal alloy at least partially bound holes in each board, an island of one board having metal or metal alloy of the island lining a hole through the board may be electrically connected to a similar island on another board by introducing a local deposit of a material of high electrical conductivity into the aligned metal lined holes sufficient to bridge the gap between the metal linings of the two aligned holes. Where one or each major surface of the rigid board has secured thereto a laminate of two or more flexible sheets of electrically insulating material, each of which carries on the surface of the sheet remote from the rigid board a multiplicity of islands of metal or metal alloy bounding and overlying holes in the rigid board, each of which flexible sheets - except the flexible sheet immediately adjacent and secured to the rigid board -being secured to the underlying flexible sheet, a pin urged through an electrically conductive island on an uppermost sheet and through an electrically conductive island on an underlying sheet into an underlying hole in the rigid board will effect electrical contact with and between the electrically conductive islands of the two sheets.

In all cases, the rigid board may be made wholly of any suitable electrically insulating material, preferred materials being resin bonded glass fibre, synthetic resin bonded paper and ceramics, or the rigid board may be made of a sheet of metal or metal alloy coated with an electrically insulating material, e.g. an electrically insulating plastics material.

The required pattern of electrically conductive islands may be formed by coating with copper and forming the required pattern by the conventional photo-engraving technique currently employed to form a pattern of copper strips and/or pads during manufacture of a circuit board of the kind described. Where the multiplicity of electrically conductive islands is carried on a surface of a flexible sheet, preferably before the flexible sheet is secured to the rigid board the required pattern of electrically conductive islands is formed either by printing the required pattern of islands directly on to a copper coating on the flexible sheet with an etch-resistant ink, etching away the exposed copper, and removing the etch-resistant ink with an appropriate solvent to leave, on the surface of the flexible sheet, the required pattern of copper islands of appropriate thickness, or by printing the required pattern of electrically conductive islands directly on to a surface of the electrically insulating flexible sheet using an electrically conductive ink and then coating or plating the electrically conductive ink to the required thickness with a metal or metal alloy of high electrical conductivity, e.g. nickel or copper.

Printing of the required pattern of islands either with an etch-resistant ink or with an electrically conductive ink can be readily effected using a computer aided design plotter (CAD).

Furthermore, since the or each flexible sheet of electrically insulating material is separately formed with respect to the rigid board and a required pattern of islands can be printed on the or each flexible sheet with either an etch-resistant ink or an electrically conductive ink using a computer aided design plotter (CAD), a flexible sheet or flexible sheets of electrically insulating material carrying the required pattern or patterns of electrically conductive islands can be readily formed and an improved circuit board readily assembled by a user rather than by a manufacturer.

The present invention also includes a kit of parts for use in the construction of a circuit board assembly, which kit comprises at least two improved circuit boards, each comprising a substantially rigid board of which at least the major surfaces are of electrically insulating material, which has extending through the rigid board a multiplicity of holes arranged in a pattern of rows and columns and which carries on one or each of its major surfaces a multiplicity of islands of metal or metal alloy of high electrical conductivity, each of which islands at least partially bounds a hole in the board and is discrete with respect to the other said islands; at least one sheet of electrically insulating material having a multiplicity of holes arranged in a pattern of rows and columns similar to that of the multiplicity of holes of each circuit board; means for securing together an adjacent circuit board and sheet, e.g. an adhesive or double-sided adhesive tape; and a material of high electrical conductivity in liquid or semi liquid form, e.g. an electrically conductive ink, for locally depositing on a surface of a board to bridge and effectively interconnect adjacent islands.

The present invention further includes a kit of parts for use in the assembly of a circuit board as hereinbefore described, which kit of parts comprises at least one substantially rigid board of which at least the major surfaces are of electrically insulating material and which has extending through the rigid board a multiplicity of holes arranged in a pattern of rows and columns; at least one separately formed flexible sheet of electrically insulating material carrying on at least one surface of the sheet a multiplicity of islands of metal or metal alloy of high electrical conductivity arranged in a pattern of rows and columns similar to that of the multiplicity of holes of the or each rigid board, each of which islands is discrete with respect to the other said islands; and means for securing the flexible sheet to a surface of the rigid board or one of the rigid boards or to an underlying flexible sheet, the metal or metal alloy of each island being of such thickness that, when the flexible sheet is secured to the rigid board and a pin is urged through an electrically conductive island into an underlying hole in the rigid board, metal or metal alloy pierced by the pin will effect an electrical contact with the pin passing therethrough;

The latter kit of parts preferably also includes electrically conductive ink, thinners and cleaners to suit the pen or an applicator of a computer aided design plotter (CAD) and any one or more of pin-insertion equipment, at least one punching pin, at least one substantially rigid backing board having extending through the board a multiplicity of holes arranged in a pattern of rows and columns corresponding to the pattern of holes in the or each rigid board of the kit of parts, and a plurality of at least one kind of contact pin.

The invention is further illustrated by a description, by way of example, of four preferred forms of the improved circuit board and of two preferred forms of multi-layer circuit board assemblies constructed from improved circuit boards, with reference to the accompanying drawings, in which:-

Figures 1 to 4, respectively, are fragmental plan views of the four preferred forms of the improved circuit board,

Figure 5 is a fragmental sectional side view, shown on an enlarged scale, of a first preferred form of multi-layer circuit board assembly, and

Figure 6 is a fragmental sectional side view, drawn on an enlarged scale, of the second preferred form of multi-layer circuit board assembly.

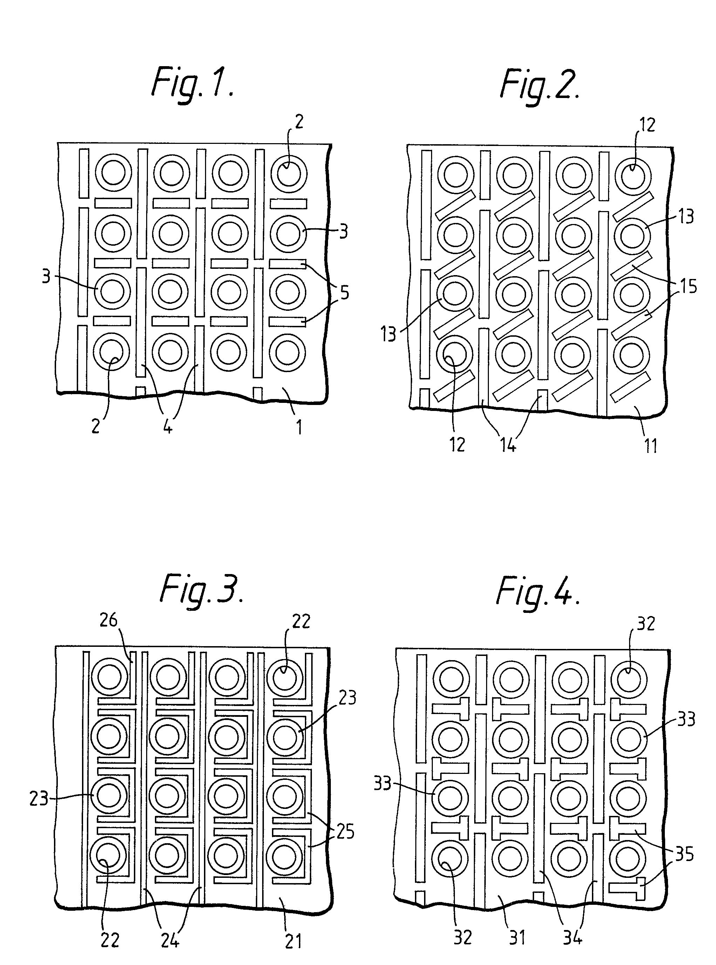

Referring to Figure 1, the first preferred form of the improved circuit board comprises a rigid board 1 of resin bonded glass fibre which has extending through the board a multiplicity of holes 2 arranged in a pattern of rows and columns. On each of its major surfaces, the rigid board carries a multiplicity of annular islands 3 of copper, each of which wholly bounds a hole in the board and is discrete with respect to the other annular islands. Copper of the annular island 3 bounding each hole 2 extends into and lines the hole over the whole of its length.

The rigid board 1 also carries on each major surface supplementary islands 4 of copper in the shape of rectilinear tracks which are positioned between and parallel to adjacent columns of the holes 2 and which are discrete with respect to the annular islands 3. The rigid board 1 further carries on each major surface supplementary islands 5 of copper in the shape of rectangular pads which are positioned between and parallel to adjacent rows of the holes 2 and which are discrete with respect to the annular islands 3 and supplementary islands 4.

The second preferred form of circuit board shown in Figure 2 is similar to the circuit board shown in Figure 1 and corresponding components of the board have been given references greater by 10 than the references of the corresponding components of the circuit board shown in Figure 1. In the circuit board shown in Figure 2, the copper islands 15 positioned between adjacent rows of the holes 12 are each in the form of a rectangular pad which is inclined at an acute angle to the rectilinear tracks constituting supplementary islands 14 positioned between adjacent columns of the holes 12.

In each of the circuit boards shown in Figures 1 and 2, the supplementary islands are arranged in a substantially constant pattern.

The third preferred form of circuit board shown in Figure 3 comprises a rigid board 21 of resin bonded glass fibre which has extending through the board a multiplicity of holes 22 arranged in a pattern of rows and columns. The board 21 carries on each of its major surfaces a multiplicity of annular islands 23 of copper, each of which wholly bounds a hole 22 in the board and is discrete with respect to the other annular islands. Copper of the annular island 23 bounding each hole 22 extends into and lines the hole throughout its length. Extending between and parallel to each pair of adjacent columns of the holes 22 is a longitudinally continuous rectilinear track 24 of copper. Each hole 22 in each row of holes, with the exception of the outermost rows of holes, is partially bounded by a copper island 25 of approximately C-shape, the intermediate limb of the C extending parallel to and spaced from the adjacent track 24 and each of the other limbs of the C-shaped island extending between adjacent holes in the column in which the hole partially bounded by the C-shaped island lies. In each of the outermost rows of holes 22, each hole is partially bounded by a copper island 26 of approximately L-shape, one limb of the L-shaped island extending parallel to and spaced from the adjacent track 24 and the other limb of the L-shaped island lying between the hole it partially bounds and the adjacent hole in the same column.

In the fourth preferred form of circuit board shown in Figure 4, a rigid board 31 of resin bonded glass fibre has extending through the board a multiplicity of holes 32 arranged in a pattern of rows and columns and, on each major surface of the board, each hole is wholly bounded by an annular island 33 of copper, the copper extending into and lining the hole over the whole of its length. Between adjacent columns of holes 32 are a plurality of rectilinear tracks 34 of copper constituting islands discrete with respect to each other and to the annular islands 33. Between adjacent rows of holes 33 is a plurality of approximately T-shaped pads 35 of copper which are discrete with respect to each other, to the annular islands 33 and to the tracks 34.

Using each of the preferred forms of circuit board shown in Figures 1 to 4, a circuit of either a standard or non-standard pattern can be readily formed on the major surface of the circuit board by electrically interconnecting selected adjacent copper islands with local deposits of a material of high electrical conductivity in such a way as to bridge the gap between the adjacent islands. These local deposits may be effected manually in accordance with a selected pattern by means of a pen or they may be readily effected automatically using a modified computer aided design plotter or an automatic fluid dispensing machine which can be used to operate a pen or applicator by pulses of air pressure to deposit electrically conductive material on to the rigid board of the circuit board.

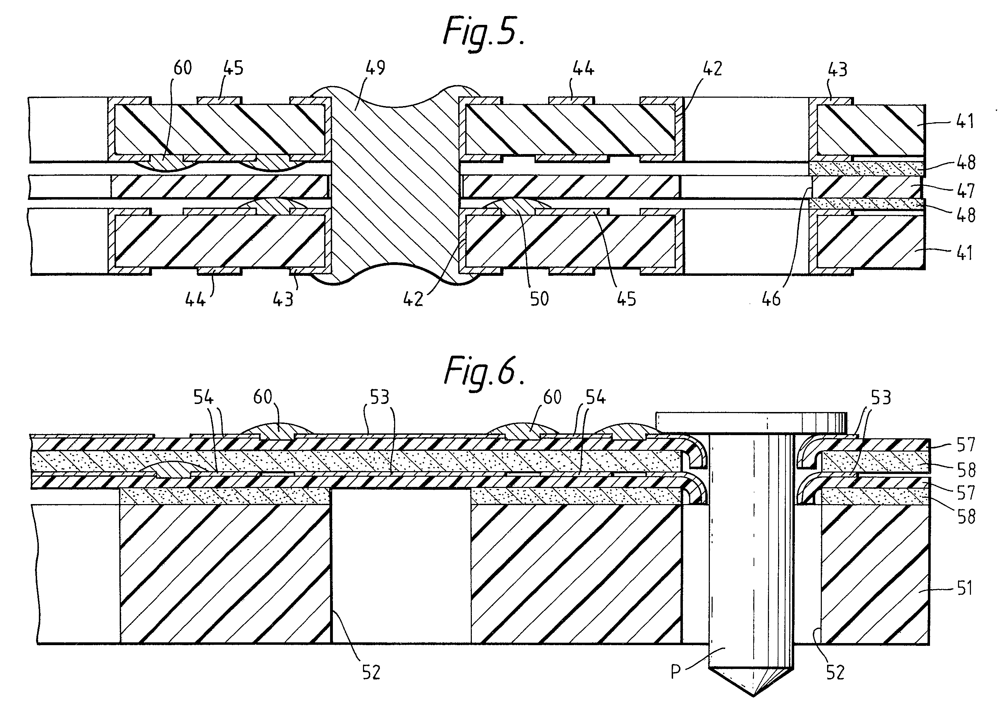

The first preferred form of multi-layer circuit board assembly shown in Figure 5 comprises two improved circuit boards, each as described with reference to Figure 1, secured one on top of the other with a preformed layer 47 of electrically insulating material sandwiched between the circuit boards and secured to them by adhesive 48 around their peripheries and, where necessary at selected areas of the boards. The preformed layer 47 of electrically insulating material has a multiplicity of holes 46 in alignment with the multiplicity of holes 42 in the rigid board 41 of each circuit board. The rigid board 41 of each circuit board carries on each of its major surfaces a multiplicity of annular islands 43 of copper, each of which surrounds a hole in the board and is discrete with respect to the other islands, the copper of the islands 43 extending into and lining the holes throughout their lengths. Between and parallel to adjacent columns of the holes 42 on each surface of the rigid board 41 are rectilinear tracks 44 of copper and between and parallel to adjacent rows of the holes 42 on the same major surface of the board are rectangular copper pads 45. An annular island 43 of one circuit board is electrically connected to the adjacent annular island 43 on the other circuit board by introducing a local deposit 49 of an electrically conductive ink into the aligned copper lined holes sufficient to bridge the gap between the metal linings of the two aligned holes. Where required, adjacent annular copper islands 43 and tracks 44 or pads 45 are electrically interconnected by local deposits 50 of an electrically conductive ink .

In the second preferred form of multi-layer circuit board assembly shown in Figure 6, a rigid board 51 of resin bonded glass fibre has extending through the board a multiplicity of holes 52 arranged in a pattern of rows and columns. Secured to one major surface of the board by adhesive 58 is a flexible sheet 57 of a polyimide which carries on the surface of the sheet remote from the rigid board a multiplicity of circular islands 53 of copper overlying holes 52 in the rigid board. Each circular island 53 is discrete with respect to the other circular islands on the surface of the sheet. Also carried on this surface of the flexible sheet 57 between adjacent circular islands 53 are a multiplicity of islands 54 of copper which are discrete with respect to the other islands 54 and to the circular islands 53. A similar flexible sheet 57 carrying on the surface of the sheet remote from the rigid board 51 a multiplicity of islands 53 and 54 of copper is secured to the underlying flexible sheet by adhesive 58. As will be seen on referring to Figure 6, when a pin P is urged through a circular island 53 of copper of the uppermost flexible sheet 57 and through a circular island 53 on the underlying flexible sheet 57 into an underlying hole 52 in the rigid board 51, the pin will effect electrical contact with and between the copper islands 53 of the two sheets. Adjacent circular islands 53 and copper islands 54 are electrically connected together by local deposits 60 of an electrically conductive ink as required.

## Claims

1. A circuit board comprising a substantially rigid board (1,11,21,31) of which at least the major surfaces are of electrically insulating material and which has extending through the rigid board a multiplicity of holes (2,12,22,32) arranged in a pattern of rows and columns, characterised in that the board carries on one or each of its major surfaces a multiplicity of islands (3,13,23,33) of metal or metal alloy of high electrical conductivity, each of which islands at least partially bounds a hole in the board and is discrete with respect to the other said islands.

2. A circuit board as claimed in Claim 1, characterised in that the board also carries on said one or each of its major surfaces supplementary islands (4,5;14,15;24,25;34,35;) of metal or metal alloy of high electrical conductivity. each of which supplementary islands is positioned between and is discrete with respect to islands (3,13,23,33) at least partially bounding adjacent holes in the rigid board.

3. A circuit board as claimed in Claim 2, characterised in that the supplementary islands (4,5;14,15;24,25;34,35) are arranged in a substantially constant pattern.

4. A circuit board as claimed in Claim 2 or 3, characterised in that the supplementary islands (4,5;14,15;24,25;34,35) are of several shapes differing from one another.

5. A circuit board as claimed in any one of Claims 2 to 4, characterised in that at least some of the supplementary islands (4,5;14,15;24;34;) are short tracks of rectilinear shape.

6. A circuit board as claimed in any one of the preceding Claims, characterised in that the metal or metal alloy of each island (3,13,23,33) at least partially bounding a hole in the rigid board extends into and aligns the hole over at least a part of its length.

7. A circuit board as claimed in any one of the preceding Claims, characterised in that the islands 3,13,23,33) at least partially bounding holes in the rigid board are of substantially the same shape as one another.

8. A circuit board as claimed in Claim 7, characterised in that the islands (3,13,23,33) at least partially bounding holes in the rigid board each has an outer periphery of substantially circular shape.

9. A circuit board as claimed in Claim 1, characterised in that the islands (53) of metal or metal alloy, each at least partially bounding a hole (52) in the rigid board 51, are carried on a surface of a separately formed flexible sheet (57) of electrically insulating material secured to one or each major surface of the rigid board and overlie holes in the board, said surface of the flexible sheet being remote from the rigid board and the metal or metal alloy of each island being of such thickness that, when a pin P is urged through an electrically conductive island into an underlying hole in the rigid board, metal or metal alloy pierced by the pin will effect an electrical contact with the pin passing therethrough.

10. A circuit board as claimed in Claim 9, characterised in that the or each flexible sheet (57) is made of an electrically insulating plastics material having such inherent elasticity that, when the flexible sheet is pierced by a pin P, the inherent elasticity of the plastics material tends to urge the metal or metal alloy of the pierced island into electrical contact with the pin.

11. A circuit board as claimed in Claim 9 or 10, characterised in that the separately formed flexible sheet (58) of electrically insulating material also carries on the surface of the flexible sheet remote from the rigid board (51) supplementary islands (54) of metal or metal alloy of high electrical conductivity, each of which supplementary islands is positioned between and is discrete with respect to islands bounding and overlying adjacent holes in the rigid board.

12. A kit of parts for use in the construction of a circuit board assembly, characterised in that the kit comprises at least two circuit boards, each comprising a substantially rigid board (41) of which at least the major surfaces are of electrically insulating material, which has extending through the rigid board a multiplicity of holes (42) arranged in a pattern of rows and columns and which carries on one or each of its major surfaces a multiplicity of islands (43) of metal or metal alloy of high electrical conductivity, each of which islands at least partially bounds a hole in the board and is discrete with respect to the other said islands; at least one sheet (47) of electrically insulating material having a multiplicity of holes (46) arranged in a pattern of rows or columns similar to that of the multiplicity of holes of each circuit board; means (48) for securing together an adjacent circuit board and sheet; and a material (49,50) of high electrical conductivity in liquid or semi-liquid form for locally depositing on a surface of a board to bridge and effectively interconnect adjacent islands.

13. A kit of parts as claimed in Claim 12, characterised in that the rigid board (41) of each circuit board also carries on said one or each of its major surfaces supplementary islands (44,45) of metal or metal alloy of high electrical conductivity, each of which supplementary islands is positioned between and is discrete with respect to islands (43) at least partially bounding adjacent holes in the rigid board.

14. A kit of parts for use in the assembly of a circuit board, characterised in that the kit of parts comprises at least one substantially rigid board (51) of which at least the major surfaces are of electrically insulating material and which has extending through the rigid board a multiplicity of holes (52) arranged in a pattern of rows and columns; at least one separately formed flexible sheet (57) of electrically insulating material carrying on at least one surface of the sheet a multiplicity of islands (53) of metal or metal alloy of high electrical conductivity arranged in a pattern of rows and columns similar to that of the multiplicity of holes of the or each rigid board, each of which islands is discrete with respect to the other said islands; and means (58) for securing the flexible sheet to a surface of the rigid board or one of the rigid boards or to an underlying flexible sheet; the metal or metal alloy of each island being of such thickness that, when the flexible sheet is secured to the rigid board and a pin P is urged through an electrically conductive island into an underlying hole in the rigid board, metal or metal alloy pierced by the pin will effect an electrical contact with the pin passing therethrough.

Fig.1.

Fig.2.

Fig.3.

Fig.4.

Fig.5.

Fig.6.